# EUROPEAN PATENT SPECIFICATION

(11) **EP 0 770 925 B1**
(45) Date of publication and mention of the grant of the patent: **02.01.2002**
(21) Application number: 96116273.2
(22) Date of filing: 10.10.1996
(51) Int. Cl.: G03F 7/20, B23K 26/06

(54) **Photoprocessing method and apparatus**
Verfahren und Vorrichtung zur optischen Behandlung
Méthode et dispositif de traitement optique

(30) Priority: 11.10.1995 JP 26282195; 12.10.1995 JP 29220195
(43) Date of publication of application: 02.05.1997
(73) Proprietor: Sanyo Electric Co., Ltd., Moriguchi-shi, Osaka (JP)
(72) Inventor: Wataru, Shinohara, Hirataka-shi, Osaka (JP); Seiichi, Kiyama, Takatsuki-shi, Osaka (JP); Yasuaki, Yamamoto, Higashiosaka-shi, Osaka (JP); Shingo, Nakano, Hirakata-shi, Osaka (JP)
(74) Representative: Glawe, Delfs, Moll & Partner

(56) References cited:
- EP-A- 0 668 541
- EP-A- 0 679 469
- WO-A-96/26466
- DE-A- 3 912 188
- DE-A- 19 503 675
- US-A- 5 011 253
- US-A- 5 223 693
- US-A- 5 290 992
- US-A- 5 414 239
- US-A- 5 473 408
- PATENT ABSTRACTS OF JAPAN vol. 016, no. 534, 4 November 1992 & JP 04 200886 A (HITACHI LTD)
- PATENT ABSTRACTS OF JAPAN vol. 012, no. 149, 10 May 1988 & JP 62 270293 A (TOSHIBA CORP)

## Description

The present invention relates generally to a photoprocessing method for processing an object to be processed by irradiating a laser beam onto the object to be processed, and more particularly, to a photoprocessing method for simply and accurately processing an object to be processed in a short time. The invention also relates to a corresponding photoprocessing apparatus.

In fabricating a photovoltaic device, a thin film transistor (hereinafter referred to as a TFT) and the like, a photoprocessing method for processing an object to be processed by irradiating a laser beam onto the object to be processed has been conventionally employed.

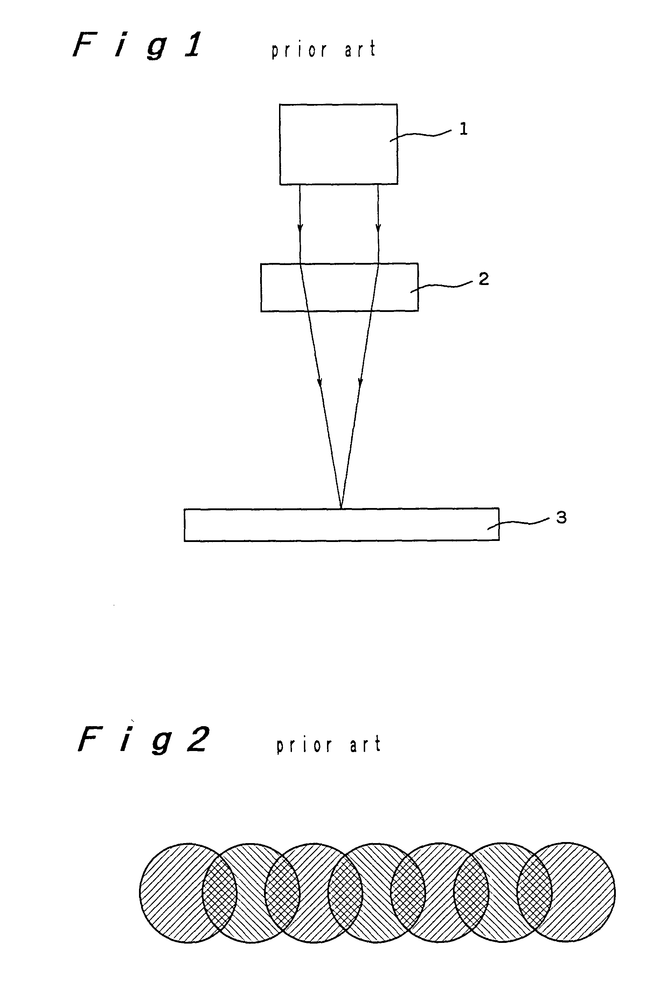

In thus processing the object to be processed using the laser beam, an object to be processed 3 has been conventionally subjected to processing in various shapes by gathering a laser beam emitted from a laser device 1 using an optical system 2 such as a lens, irradiating the laser beam which is gathered to be brought into a spot shape onto the object to be processed 3, and scanning the laser beam, as shown in Fig. 1.

When the laser beam emitted from the laser device 1 is thus gathered by the optical system 2 such as a lens, a Gaussian distribution occurs in the energy intensity of the laser beam by the light gathering. Consequently, energy in the center of the laser beam becomes higher than energy in the periphery thereof.

When processing is performed by thus irradiating the gathered laser beam onto the object to be processed 3, therefore, the energy intensity differs in the center and the periphery of the laser beam, whereby the processing cannot be constantly performed.

Furthermore, when processing is performed by scanning the laser beam in a spot shape as described above, the scanning speed and the like must be suitably controlled depending on a material for the object to be processed 3, whereby the control is difficult. When the object to be processed 3 is subjected to processing in various shapes, the laser beam must be scanned along the shape thereof, whereby the processing in a complicated shape becomes difficult, and a lot of time is required to perform the processing, resulting in very poor productivity.

Additionally, when processing is performed by scanning the laser beam in a spot shape as described above, there occurs a portion where spots of the laser beam are overlapped with each other, as shown in Fig. 2. In the portion where spots are overlapped with each other and the other portion, the energy intensity of the laser beam to be irradiated differs. In the portion where the laser beam is so irradiated that the spots thereof are overlapped with each other, there are some problems. For example, the object to be processed 3 is degraded.

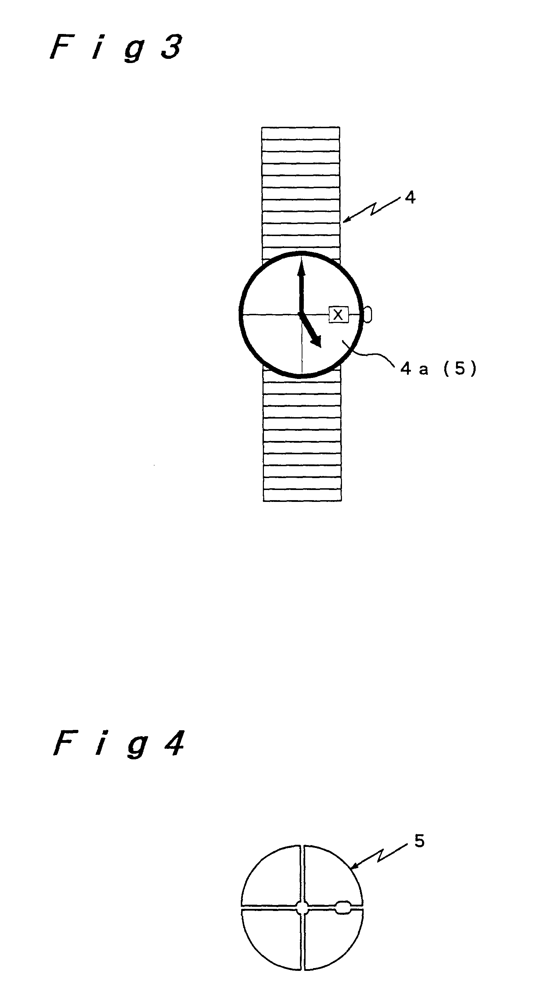

Furthermore, in recent years, a photovoltaic device 5 has been employed for a dial 4a of a watch 4 as shown in Fig. 3. Therefore, the photovoltaic device 5 in a shape as shown in Fig. 4 has been fabricated by the photoprocessing method using the laser beam.

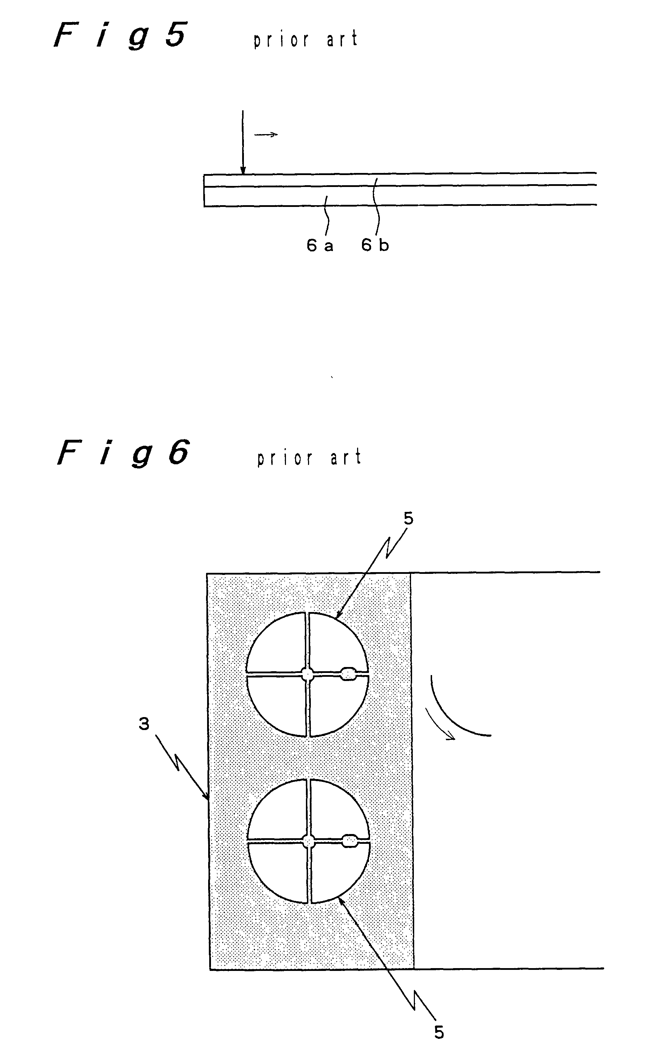

When the photovoltaic device 5 is fabricated by the above-mentioned conventional photoprocessing method, the laser beam gathered as described above is first irradiated onto a metal electrode 6b formed on a substrate 6a as shown in Fig. 5, and the laser beam is scanned as shown in Fig. 6, to remove the metal electrode 6b and provide a plurality of metal electrodes 6b in a shape corresponding to the dial 4a.

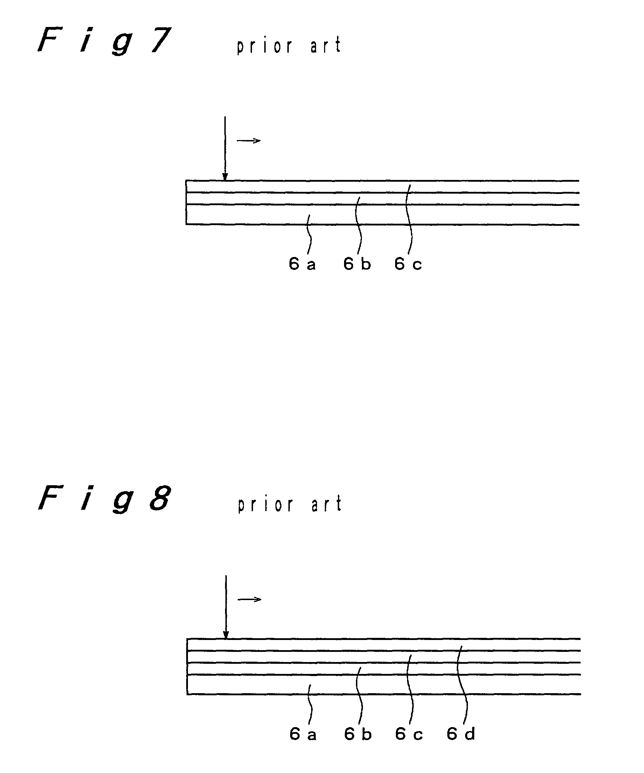

Thereafter, as shown in Fig. 7, a semiconductor layer 6c to be photoelectrically converted is formed on the metal electrode 6b, a gathered laser beam is also scanned with respect to the semiconductor layer 6c, similarly to the metal electrode 6b, to remove the semiconductor layer 6c and provide a plurality of semiconductor layers 6c in the shape corresponding to the dial 4a.

Furthermore, as shown in Fig. 8, a light-transmittable surface electrode 6d composed of ITO (indium tin oxide) or the like is formed on the semiconductor layer 6c, and a gathered laser beam is scanned with respect to the surface electrode 6d, to remove the surface electrode 6d and provide a plurality of surface electrodes 6d in the shape corresponding to the dial 4a.

When the gathered laser beam is thus scanned, to process the metal electrode 6b, the semiconductor layer 6c and the surface electrode 6d into the shape corresponding to the dial 4a one at a time, the laser beam must be scanned in a complicated manner, whereby the scanning is very difficult. Further, large areas of the metal electrode 6b, the semiconductor layer 6c and the surface electrode 6d must be removed by the laser beam in a spot shape.

Therefore, there are some problems. For example, a lot of time is required to fabricate the above-mentioned photovoltaic device 5, resulting in very poor productivity. When the laser beam is scanned in correspondence to the shape of the dial 4a, there arises a shift, for example, at the time of the scanning, to produce defective products. Further, a control mechanism for scanning the laser beam as described above is complicated, whereby a device for photoprocessing is increased in size, and the cost thereof is high.

Therefore, the inventors of the present invention have conceived a photoprocessing method so adapted as to introduce a laser beam emitted from a laser device into a mask member, pass the laser beam through a light-transmittable portion provided in the mask material, to obtain a laser beam corresponding to the pattern of the light-transmittable portion, and project the laser beam onto an object to be processed by an image forming lens, thereby to subject the object to be processed to processing corresponding to the pattern of the light-transmittable portion.

When the laser beam is merely introduced into the mask member, and is passed through the light-transmittable portion provided in the mask member, however, the laser beam is reflected by the mask member in a portion other than the light-transmittable portion, whereby the laser beam in the portion is not utilized for the processing. Particularly when the area of the light-transmittable portion is small, the amount of the laser beam which is not utilized for the processing is increased, whereby the energy of the laser beam is not effectively utilized.

Furthermore, the energy of the laser beam is not thus effectively utilized, an area which can be processed by one pulse of the laser beam is decreased. When a large area is processed, a lot of laser beams must be irradiated, resulting in poor efficiency.

DE 195 03 675 A1 discloses an optical transmitting system and a method for processing an object, wherein between a laser source and an object to be processed an optical fiber, a first lens, a mask, and a second lens are provided. The first lens serves to control the light distribution for a light transmitting portion, a hole, of the mask, and the second lens serves to focus the light transmitting through the mask on the object to be processed. Accordingly, this system corresponds to the preamble of claim 1.

EP-A1-0 679 469 discloses a similar system in which a hologram is arranged between the mask and an object to be processed to split the laser beam and to simultaneously process the object by a plurality of laser beams.

An object of the present invention is to make it possible to process, in subjecting an object to be processed to processing in a desired shape by irradiating a laser beam onto the object to be processed, the object to be processed simply in a short time and stably with high precision at low cost by eliminating the necessity of scanning the laser beam in correspondence to the shape into which the object to be processed is to be processed.

Another object of the present invention is to make it possible to process an object to be processed more efficiently by effectively utilizing the energy of a laser beam to increase an area which can be processed.

These objects are achieved by a photoprocessing method according to claim 1 and by an apparatus according to claim 6; the remaining claims are related to further developments of the invention.

In the photoprocessing method according to the present invention, in processing an object to be processed by a laser beam, the laser beam is processed so as to correspond to the shape of a light-transmittable portion formed in a mask member, the laser beam thus processed is introduced into the mask member, and the laser beam passed through the light-transmittable portion formed in the mask member is irradiated onto the object to be processed.

When the laser beam is thus introduced into the mask member, and the laser beam passed through the light-transmittable portion formed in the mask member is irradiated onto the object to be processed to perform the processing, it is not necessary that the laser beam is scanned in correspondence to the shape into which the object to be processed is to be processed as in the conventional example. Consequently, the processing corresponding to the shape of the light-transmittable portion formed in the mask member can be performed at a time, whereby the object to be processed can be simply processed in a short time.

It is not necessary that the laser beam is scanned as in the conventional example, and there is no shift, for example, at the time of scanning, whereby the processing can be performed with high precision.

Furthermore, when the laser beam is previously processed so as to correspond to the shape of the light-transmittable portion formed in the mask member as described above, and the laser beam thus processed is introduced into the mask member, the ratio of the laser beam reflected from a portion other than the light-transmittable portion in the mask member is decreased, whereby the energy of the laser beam is effectively utilized.

As a result of thus effectively utilizing the energy of the laser beam, an area which can be processed by one pulse of the laser beam is increased, and a lot of laser beams need not be irradiated to process a large area, whereby the processing can be efficiently performed in a short time.

In an embodiment of the photoprocessing method, a laser beam is introduced into a mask member having a light-shielding portion in a required shape formed therein, the laser beam passed through the mask member is projected onto an object to be processed by a projection optical system, and the object to be processed is processed by the laser beam thus projected, leaving a portion, on which the laser beam is projected, corresponding to the light-shielding portion. At least two of the position where the laser beam is irradiated, the mask member and the object to be processed are moved, to successively process the object to be processed.

When the object to be processed is thus processed, the laser beam need not be scanned in correspondence to the shape into which the object to be processed is to be processed as in the above-mentioned case, and the object to be processed can be processed, leaving the portion corresponding to the shape of the light-shielding portion formed in the mask member, whereby the object to be processed can be simply performed in a short time. In addition, there is no shift, for example, at the time of scanning, whereby the processing can be performed with high precision. Further, the object to be processed can be simply subjected to processing in various shapes by only changing the shape of the light-shielding portion formed in the mask member.

Furthermore, when the laser beam passed through the mask member is projected onto the object to be processed as described above, and the object to be processed is processed by the laser beam thus projected, a Gaussian distribution occurs in the energy intensity of the laser beam as in a case where a laser beam is gathered by an optical system such as a lens, whereby the energy in the center of the laser beam is not made higher than the energy in the periphery thereof. Therefore, a laser beam having a constant energy distribution is irradiated, whereby the processing can be constantly performed.

Furthermore, when the object to be processed is successively processed by the photoprocessing methods in the present invention, the object to be processed can be successively subjected to the above-mentioned processing by moving at least two of the position where the laser beam is irradiated, the mask member and the object to be processed.

When the position where the laser beam is irradiated is changed, however, control, for example, of the position where the laser beam is to be correctly projected becomes troublesome, whereby a device for photoprocessing is complicated. Therefore, it is preferable that in a state where the position where the laser beam is irradiated is fixed, the mask member and the object to be processed are relatively moved with respect to the laser beam. Further, when the mask member and the object to be processed are moved in opposite directions, the processing can be efficiently performed by reducing the ranges of the movement of the mask member and the object to be processed.

The foregoing and other objects, features, aspects and advantages of the present invention will become more apparent from the following detailed description of the present invention when taken in conjunction with the accompanying drawings.
Fig. 1 is a schematic illustration showing a state where an object to be processed is subjected to processing using a conventional photoprocessing method;
Fig. 2 is a schematic illustration showing a state where spots of a laser beam are overlapped with each other in the conventional photoprocessing method;
Fig. 3 is a plan view of a watch using a photovoltaic device for its dial portion;
Fig. 4 is a plan view of a photovoltaic device used for a dial portion of a watch;
Fig. 5 is an illustration showing a state where a laser beam is irradiated onto a metal electrode formed on a substrate in fabricating the photovoltaic device shown in Fig. 4 by the conventional photoprocessing method;
Fig. 6 is an illustration showing a state where a laser beam is scanned in fabricating the photovoltaic device shown in Fig. 4 by the conventional photoprocessing method;
Fig. 7 is an illustration showing a state where a laser beam is irradiated onto a semiconductor layer formed on a metal electrode in fabricating the photovoltaic device shown in Fig. 4 by the conventional photoprocessing method;
Fig. 8 is an illustration showing a state where a laser beam is irradiated onto a surface electrode formed on a semiconductor layer in fabricating the photovoltaic device shown in Fig. 4 by the conventional photoprocessing method;
Fig. 9 is a schematic illustration showing a state where a laser beam is projected and formed on an object to be processed to perform processing in a photoprocessing method according to an embodiment 1 of the present invention;
Fig. 10 is a plan view showing a part of a mask member used in the photoprocessing method according to the embodiment 1;
Fig. 11 is a plan view showing a state where a laser beam is processed into a shape corresponding to a light-transmittable portion of a mask member in the photoprocessing method according to the embodiment 1;
Fig. 12 is a schematic illustration showing a state where a laser beam is projected and formed on an object to be processed, to perform processing in a photoprocessing method according to an embodiment 2 of the present invention;
Fig. 13 is a plan view showing a part of a mask member used in the photoprocessing method according to the embodiment 2;
Fig. 14 is a plan view showing a state where a laser beam in a surface shape is irradiated onto one light-shielding portion in a mask member and the periphery thereof in the photoprocessing method according to the embodiment 2;
Figs. 15 (A), 15 (B) and 15 (C) are schematic illustrations showing the steps of fabricating a photovoltaic device used for a dial portion of a watch in the photoprocessing method according to the embodiment 2;

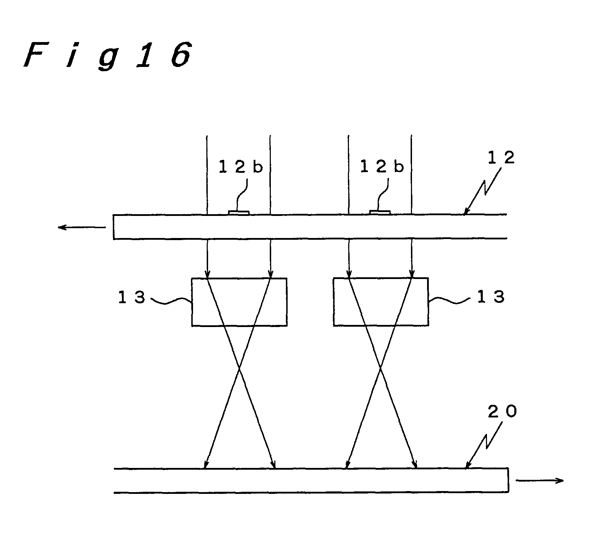

Fig. 16 is a schematic illustration showing a state where two laser beams are irradiated at a time to perform preliminary processing and finish processing in the photoprocessing method according to the embodiment 2; and
Fig. 17 is a schematic illustration showing a state where a laser beam is formed and projected on an object to be processed to perform processing in a photoprocessing method according to an embodiment 3 of the present invention.

As a laser beam used in the present invention, various types of laser beams such as a gas laser and a solid state laser can be used. A laser beam having a suitable wavelength and energy is used depending on a material for an object to be processed.

Furthermore, when the laser beam is irradiated to process the object to be processed, it is preferable to use a laser beam whose energy distribution is hardly changed in order to prevent irregularity in processing, and homogenize the energy distribution of the laser beam using homogenizing means such as a homogenizer before the laser beam is introduced into a mask member.

Additionally, as the mask member, a mask member composed of a material which is hardly degraded by a laser beam is used. For example, a photomask composed of a multilayer or monolayer dielectric film, or a metal thin film and a quartz glass substrate, a metal mask, and the like are used.

Description is now made of specific embodiments of the photoprocessing method according to the present invention on the basis of drawings.

### (Embodiment 1)

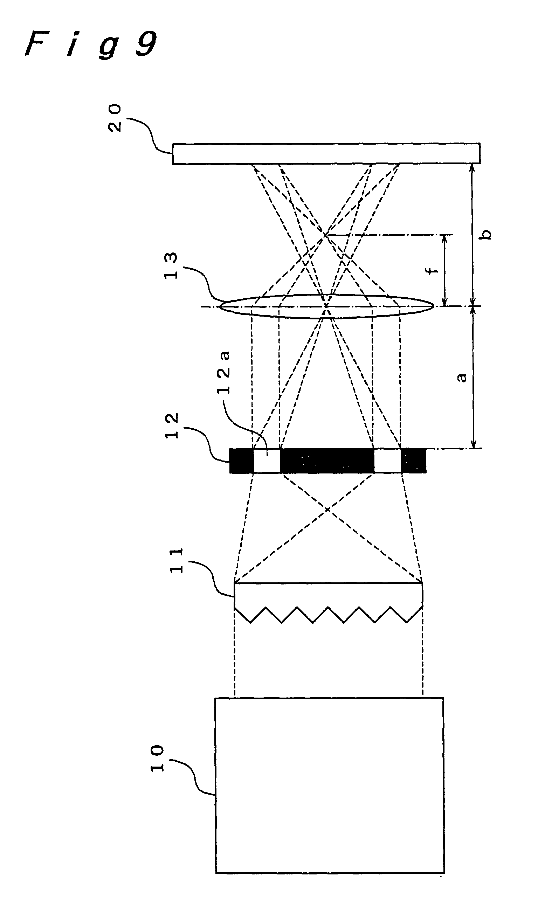

In a photoprocessing method according to the present embodiment, a laser beam irradiated from a laser device 10 is introduced into a light guide 11, and the laser beam is processed so as to correspond to the shape of a light-transmittable portion 12a having a desired pattern formed in a mask member 12 by the light guide 11, as shown in Fig. 9.

As the laser beam, a laser beam having a suitable energy and wavelength is selectively used depending on a material for an object to be processed which is processed in the above-mentioned manner. Examples of the laser beam include second higher harmonic waves of a KrF laser having a wavelength of 248 nm, an ArF eximer laser having a wavelength of 193 nm, an XeCl eximer laser having a wavelength of 308 nm, an Ar laser having a wavelength of 515 nm, and a YAG laser having a wavelength of 530 nm.

Examples of the light guide 11 for processing such a laser include a diffraction optical system composed of a Fresnel lens array, a diffraction grating, a grating and the like, a spherical lens, a cylindrical lens, an achromatic lens, or a lens which is a combination of the lenses, and an optical fiber. When a laser beam having a small wavelength such as an eximer laser is used as the laser beam, it is preferable to use as the above-mentioned lens a ultraviolettransmittable member which is a combination of quartz or MgF₂, CaF₂ or the like and a multilayer or monolayer dielectric film.

The laser beam processed by the light guide 11 in the above-mentioned manner is introduced into the mask member 12, and the laser beam is passed through the light-transmittable portion 12a formed in the mask member 12, to obtain a laser beam in a shape corresponding to the pattern of the light-transmittable portion 12a.

Furthermore, the laser beam thus passed through the light-transmittable portion 12a is introduced into an image forming lens 13, the laser beam is formed and projected on an object 20 to be processed by the image forming lens 13, and the object 20 to be processed is processed by the laser beam thus formed and projected.

In forming and projecting the laser beam in the shape corresponding to the pattern of the light-transmittable portion 12a on the object to be processed 20 by the image forming lens 13, the mask member 12, the image forming lens 13 and the object to be processed 20 are so arranged that letting a be the distance between the mask member 12 and the image forming lens 13, b be the distance between the image forming lens 13 and the object to be processed 20, and f be the focal length of the image forming lens 13, a relationship of 1 / a + 1 / b = 1 / f is satisfied in order that an image of the laser beam is satisfactorily formed on the object 20 to be processed. It is preferable that a spherical convex and concave lens made of synthetic quartz, an achromatic lens, or a lens in which abbreviation is removed by combining the lenses are used as the above-mentioned image forming lens 13.

When the laser beam introduced into the mask member 12 as described above is previously processed so as to correspond to the shape of the light-transmittable portion 12a, the ratio of the laser beam reflected by a light-shielding portion 12b other than the light-transmittable portion 12a is reduced, whereby the laser beam irradiated from the laser device 10 is effectively utilized.

Furthermore, when the laser beam thus processed is passed through the light-transmittable portion 12a in the mask member 12, and the laser beam is formed and projected on the object 20 to be processed by the image forming lens 13, to process the object 20 to be processed, processing in a shape corresponding to the pattern of the light-transmittable portion 12a can be simply performed at a time, and the possibility that a Gaussian distribution occurs in the energy intensity of the laser beam as in a case where light is gathered using a condenser lens is eliminated. Therefore, the laser beam having a uniform energy distribution is irradiated, whereby the processing can be constantly performed with respect to the object 20 to be processed. Description is now made of a case where a photovoltaic device 5 used for the dial 4a of the watch 4 shown in Figs. 3 and 4 is fabricated by the photoprocessing method according to the present embodiment.

A KrF laser having a wavelength of 248 nm is used as the laser beam, and the laser beam having dimensions of 12 mm x 20 mm is irradiated from the laser device 10.

In order to perform uniform processing, it is preferable that the energy distribution of the laser beam irradiated from the laser device 10 is made uniform by a homogenizer.

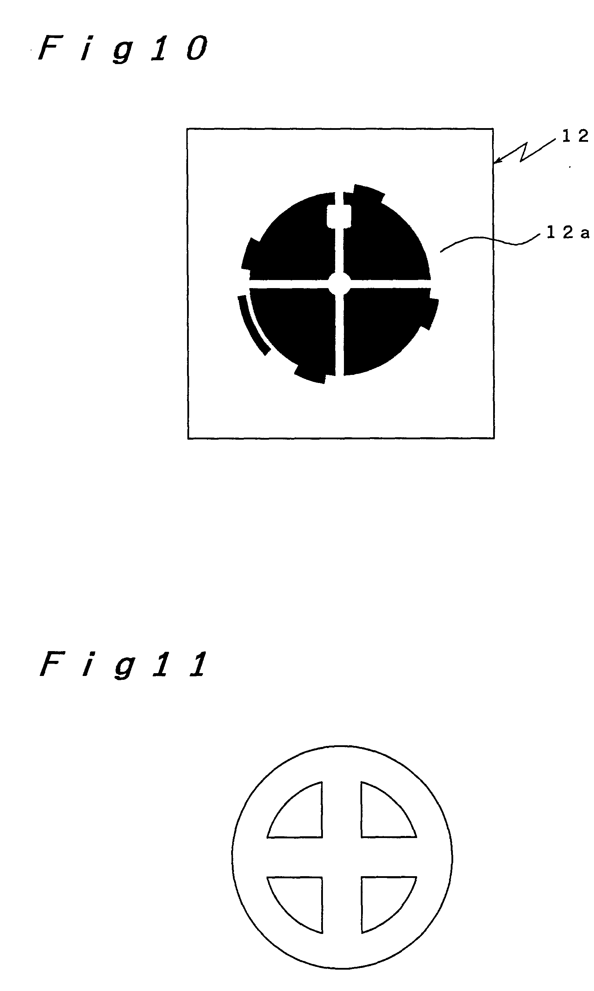

The laser beam is processed into a plane shape as shown in Fig. 11 by the light guide 11 composed of a Fresnel lens array so as to correspond to the shape of the light-transmittable portion 12a in the mask member 12 shown in Fig. 10. In processing the laser beam, the processing may be so performed that the laser beam has entirely the same shape as that of the light-transmittable portion 12a. Since the energy in the periphery of the laser beam is generally low, however, it is preferable that the laser beam is processed into a shape having a slightly larger area than that of the light-transmittable portion 12a, and the laser beam in the periphery where energy is low is reflected by the mask member 12 and is removed when it is passed through the light-transmittable portion 12a.

The laser beam processed so as to correspond to the shape of the light-transmittable portion 12a as described above is introduced into the mask member 12 and is passed through the light-transmittable portion 12a provided in the mask member 12, to obtain a laser beam corresponding to the shape of the light-transmittable portion 12a and having a uniform energy distribution. In order to effectively utilize the laser beam irradiated onto a light-shielding portion 12b other than the light-transmittable portion 12a, it is also possible to provide a reflector for reflecting the laser beam reflected by the mask member 12 and introduce the laser beam reflected by the reflector into the mask member 12 again.

The laser beam passed through the light-transmittable portion 12a as described above is introduced into the image forming lens 13, and the laser beam is formed and projected on the object to be processed by the image forming lens 13, to process the object to be processed by the laser beam thus formed and projected.

In thus forming and projecting the laser beam, a lens having a magnification of 1 : 1 is used as the image forming lens 13 in the present embodiment, so that a laser beam having a shape corresponding to the pattern of the light-transmittable portion 12a provided in the mask member 12 is formed and projected on the object to be processed 20 at a 1 : 1 magnification, to subject the object to be processed 20 to processing with the same pattern as that of the light-transmittable portion 12a.

When the object 20 to be processed is thus processed, the processing with the same pattern as that of the light-transmittable portion 12a can be simply performed at a time. Further, the laser beam introduced into the mask member 12 is previously processed so as to correspond to the light-transmittable portion 12a as described above, whereby the ratio of the laser beam reflected by the light-shielding portion 12b other than the light-transmittable portion 12a is small, and the laser beam irradiated from the laser device 10 is effectively utilized, thereby making it possible to process a large area.

Furthermore, when an optical fiber bundle is used as the light guide 11, the laser beam irradiated from the laser device 10 can be branched by the optical fiber bundle and introduced into a plurality of mask members 12, whereby a plurality of objects to be processed can be processed in one step, and the object to be processed can be simultaneously subjected to processing with a plurality of patterns.

### (Embodiment 2)

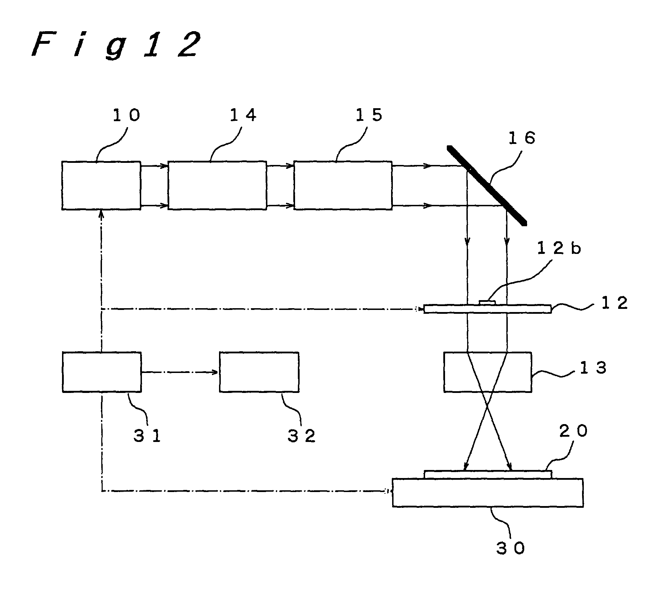

In a photoprocessing method according to the present embodiment, a laser beam is emitted from a laser device 10 which oscillates a laser beam such as an eximer laser, and the laser beam is formed into a predetermined shape by an optical system 14 composed of a slit, a beam expander and the like, after which the energy distribution of the laser beam is homogenized by an optical system 15 such as a homogenizer, as shown in Fig. 12.

The laser beam whose energy distribution is thus homogenized in a predetermined cross-sectional shape is reflected by a mirror 16, the laser beam is introduced into a mask member 12 having a light-shielding portion 12b in a required shape formed therein, and the laser beam is reflected from the light-shielding portion 12b formed in the mask member 12, while being passed through a light-transmittable portion 12a excluding the light-shielding portion 12b in the mask member 12.

The laser beam thus passed through the mask member 12 is projected and formed on an object to be processed 20 by a projection optical system 13 which is a combination of lenses, and the object 20 to be processed is processed by the laser beam thus projected and formed.

When the object 20 to be processed is thus processed, the object 20 to be processed is processed by the laser beam, leaving a portion corresponding to the light-shielding portion 12b.

In the photoprocessing method according to the present embodiment, the above-mentioned object 20 to be processed is put on an X - Y table 30 which is moved in a two-dimensional manner in X and Y directions, the movement of the X - Y table 30 and the movement of the mask member 12 are controlled by a controller 31, and the timing at which the laser beam is emitted from the laser device 10 is also controlled by the controller 31.

The X - Y table 30 on which the object 20 to be processed is put and the mask member 12 are moved by the controller 31, to set the object 20 to be processed and the mask member 12 in predetermined positions, and the laser beam is emitted from the laser device 10 by the controller 31 in synchronism therewith. Such operations are repeated, to successively process the object 20 to be processed, and the processed state is observed by a monitor 32.

A case where a photovoltaic device 5 used for the dial 4a of the watch 4 shown in Figs. 3 and 4 is fabricated using the photoprocessing method according to the present embodiment will be specifically described.

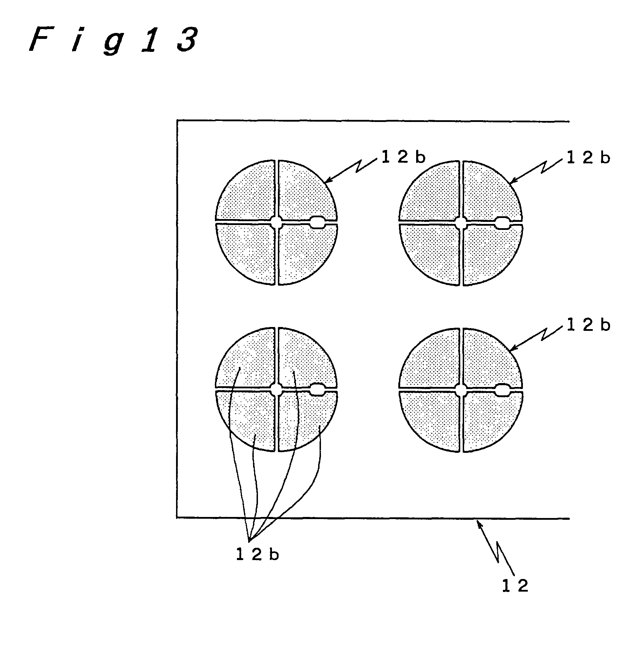

Examples of the above-mentioned mask member 12 include one having a plurality of light-shielding portions 12b corresponding to the shape of the dial 4a provided on a transparent quartz glass plate using a dielectric member such as chromium oxide for intercepting the laser beam, as shown in Fig. 13.

The laser beam emitted from the laser device 10 as described above is formed into a predetermined shape by the optical system 14 composed of a slit, a beam expander and the like, and the energy distribution of the laser beam is homogenized by the optical system 15 such as a homogenizer, after which the laser beam is reflected by the mirror 16 and is introduced into the mask member 12.

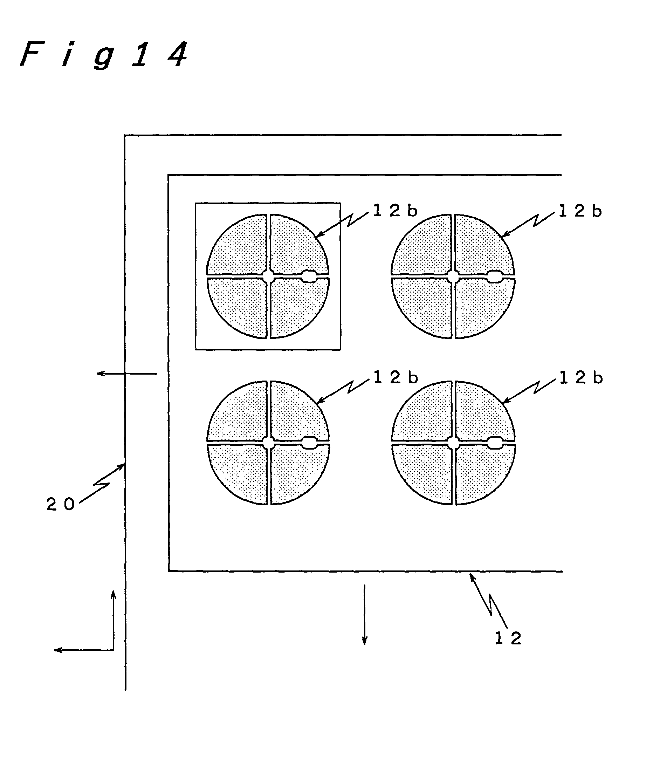

In forming the laser beam into a predetermined shape by the optical system 14 as described above, the plane shape of the laser beam introduced into the mask member 12 is made larger than one of the light-shielding portions 12b corresponding to the shape of the dial 4a provided in the mask member 12, as shown in Fig. 14, so that the laser beam is irradiated onto the light-shielding portion 12b and the periphery thereof. In order to increase the intensity of the laser beam, an area onto which the laser beam is irradiated can be also decreased. When the plane shape of the laser beam introduced into the mask member 12 is smaller than one of the light-shielding portions 12b provided in the mask member 12, the laser beam is irradiated onto a portion which is one-fourth the light-shielding portion 12b and the periphery thereof, for example. Conversely, the area of the laser beam may be increased to perform processing corresponding to the plurality of light-shielding portions 12b at a time. In this case, the speed of the processing is improved.

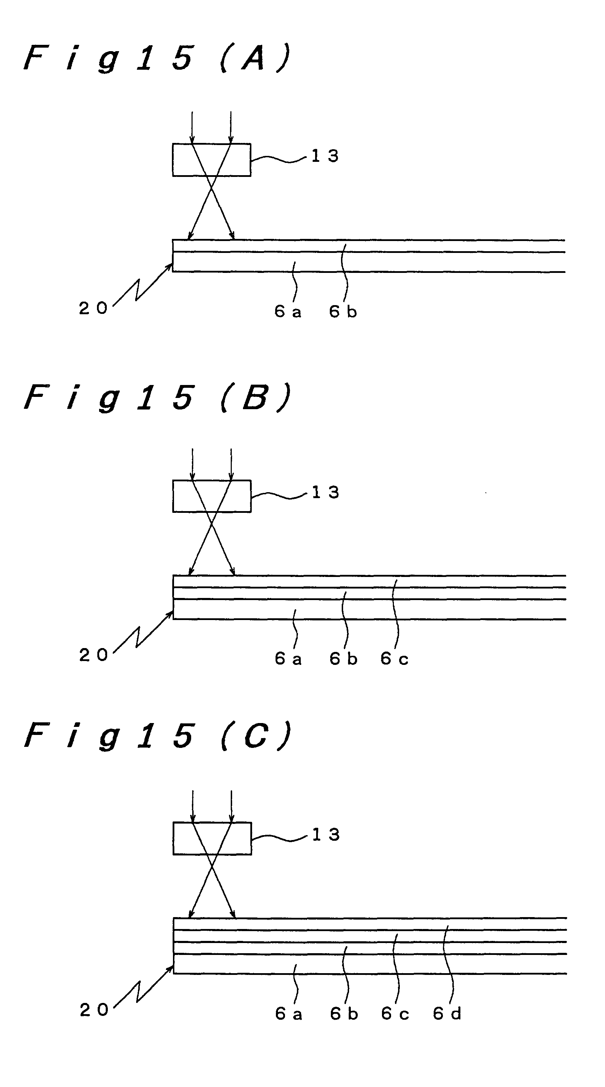

The laser beam is irradiated onto the mask member 12 as described above, the laser beam passed through the mask member 12 is introduced into the projection optical system 13 as described above, and the laser beam is projected and formed on a metal electrode 6b formed on a substrate 6a, as shown in Fig. 15 (A).

When the laser beam is thus irradiated onto the metal electrode 6b, the laser beam is not irradiated onto a portion corresponding to the light-shielding portion 12b, leaving the metal electrode 6b, while being irradiated onto the metal electrode 6b in the periphery thereof so that the metal electrode 6b is removed, whereby processing corresponding to the shape of the dial 4a can be performed at a time.

Furthermore, after the processing corresponding to the shape of the dial 4a is thus performed once on the metal electrode 6b, the X - Y table 30 is moved by the controller 31, to set the substrate 6a on which the metal electrode 6b is formed in the subsequent position, and the mask member 12 is moved as required, to set the light-shielding portions 12b provided in the mask member 12 in predetermined positions, as shown in Fig. 14.

The laser beam is emitted from the laser device 10 by the controller 31 in synchronization with the timing at which they are set, and the metal electrode 6b is subjected to processing corresponding to the shape of the dial 4a in the same manner as described above. Such operations are repeated many times, to successively subject the metal electrode 6b to the processing corresponding to the shape of the dial 4a.

In thus successively subjecting the metal electrode 6b to the processing corresponding to the shape of the dial 4a, when the position where the laser beam is irradiated is fixed, to relatively move the mask member 12 and the substrate 6a in opposite directions, the distances at which the mask member 12 and the substrate 6a are moved can be decreased, whereby time required for the processing can be significantly reduced.

After the metal electrode 6b is thus subjected to the processing corresponding to the shape of the dial 4a a lot of times, a semiconductor layer 6c to be photoelectrically converted is formed on the metal electrode 6b, as shown in Fig. 15 (B). The semiconductor layer 6c is subjected to the processing corresponding to the shape of the dial 4a, similarly to the above-mentioned metal electrode 6b. Further, a light-transmittable surface electrode 6d composed of ITO or the like is further formed on the semiconductor layer 6c, as shown in Fig. 15 (C). The surface electrode 6d is also successively subjected to the processing corresponding to the shape of the dial 4a, as in the above-mentioned case, to form a lot of photovoltaic devices 5 in the shape corresponding to the dial 4a on the substrate 6a. The photovoltaic devices 5 thus formed on the substrate 6a are cut.

The above-mentioned photovoltaic devices 5 can be fabricated more simply in a shorter time, the productivity thereof is significantly improved, the processing precision thereof is increased, and the number of processed detective products is reduced, as compared with the conventional case where the metal electrode 6b, the semiconductor layer 6c and the surface electrode 6d are subjected to the processing corresponding to the shape of the dial 4a one by one while scanning the laser beam gathered.

When the metal electrode 6b, the semiconductor layer 6c and the surface electrode 6d cannot be sufficiently processed only by irradiating the laser beam projected and formed as described above at a time, a laser beam can be continuously irradiated a plurality of times, and two laser beams can be irradiated at a time in adjacent positions, to perform preliminary processing by one of the laser beams, and then perform finish processing of a portion preliminarily processed by the other laser beam.

### (Embodiment 3)

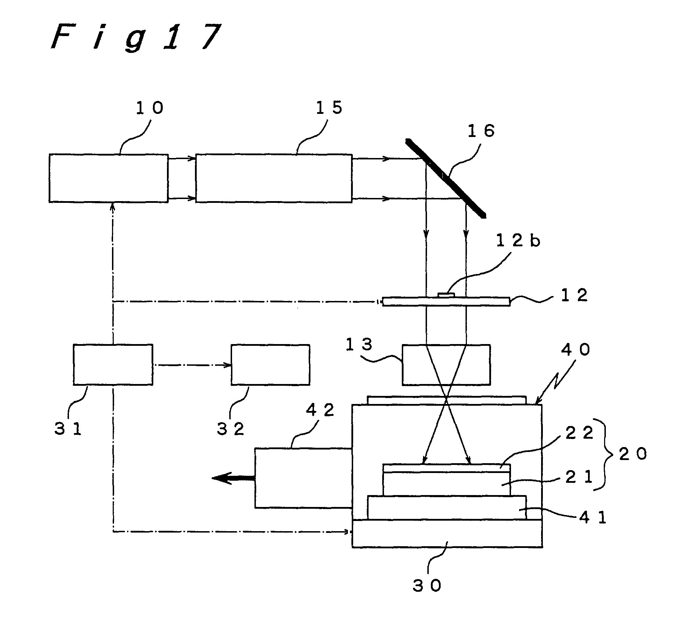

In a photoprocessing method according to the present invention, the intensity distribution of a laser beam emitted from a laser device 10 is homogenized by an optical system 14 such as a homogenizer, after which the laser beam is reflected by a mirror 16, and is introduced into a mask member 12 in which a light-shielding portion 12b in a required shape is formed, as shown in Fig. 17.

The laser beam is reflected by the light-shielding portion 12b formed in the mask member 12, while being passed through a portion other than the light-shielding portion 12b.

The laser beam thus passed through the mask member 12 is then projected and formed on an object to be processed 20 by a projection optical system 13, and is irradiated onto the object to be processed 20, and the object to be processed 20 in the periphery of a portion, on which the laser beam is projected, corresponding to the light-shielding portion 12b on which the laser beam is not irradiated is processed by the laser beam, leaving the portion corresponding to the light-shielding portion 12b.

Furthermore, also in the photoprocessing method according to the present embodiment, the object to be processed 20 is put on an X - Y table 30 which is moved in a two-dimensional manner in X and Y directions, the movement of the X - Y table 30 and the movement of the mask member 12 are controlled by a controller 31, and the timing at which the laser beam is emitted from the laser device 10 is controlled by the controller 31, as in the embodiment 2.

The X - Y table 30 on which the object to be processed 20 is put and the mask member 12 are moved by the controller 31, to set the object to be processed 20 and the mask member 12 in predetermined positions, and the laser beam is emitted from the laser device 10 by the controller 31 in synchronization therewith. Such operations are repeated, to successively process the object to be processed 20, and the processed state is observed by a monitor 32.

In the present embodiment, the object to be processed 20 is set in a chamber 40, the object to be processed 20 is heated by a heater 41, and an atmosphere in the chamber 40 is controlled by a gas controller 42.

In fabricating polycrystalline silicon TFT by the photoprocessing method according to the present embodiment, the object to be processed 20 so adapted that an amorphous silicon thin film 22 is formed on a substrate 21 is used, the object to be processed 20 is set in the chamber 40, the object to be processed 20 is heated by the heater 41, and the inside of the chamber 41 is brought into a vacuum or an atmosphere of an inert gas such as argon, helium or neon by the gas controller 42.

The laser beam passed through the mask member 12 as described above is irradiated onto the amorphous silicon thin film 22 provided on the substrate 21 in such a manner as to be projected and formed on the amorphous silicon thin film 22, leaving the portion, on which the laser beam is projected, corresponding to the light-shielding portion 12b on which the laser beam is not irradiated, to crystallize the amorphous silicon thin film in the other portion.

Thereafter, the X - Y table 30 is moved by the controller 31, to set the object to be processed 20 in the subsequent position, and the mask member 12 is also moved as required, to set the light-shielding portion 12b provided in the mask member 12 in a predetermined position.

The laser beam is emitted from the laser device 10 by the controller 31 in synchronization with the timing at which they are set, the laser beam is projected and formed on the amorphous silicon thin film 22 in the position where the object to be processed 20 is newly set in the same manner as described above, leaving the portion, on which the laser beam is projected, corresponding to the light-shielding portion 12b on which the laser beam is not irradiated, to crystallize the amorphous silicon thin film in the other portion. Such operations are repeatedly performed many times.

As a result, the amorphous silicon thin film 22 provided on the substrate 21 is crystallized in a desired plane pattern, to obtain polycrystalline silicon TFT having a desired pattern.

When the polycrystalline silicon TFT is thus fabricated, it can be fabricated more simply in a shorter time period, the productivity thereof is significantly improved, the processing precision thereof is increased, and the number of produced detective products is reduced, as compared with the conventional case where a gathered laser beam is scanned to fabricate polycrystalline silicon TFT having a required pattern.

Although in the present embodiment, the amorphous silicon thin film 22 on the substrate 21 is crystallized in a desired pattern to fabricate the polycrystalline silicon TFT, the photoprocessing method according to the present invention can be utilized for recrystallization, for example, of a compound semiconductor thin film such as GaAs or DLC (Diamond Like Carbon).

The photoprocessing method according to the present invention can be also used for patterning of an LCD (Liquid-Crystal Display), formation of a via hole for wiring of a printed circuit board, patterning of various semiconductor devices, or the like.

Although the present invention has been described and illustrated in detail, it is clearly understood that the same is by way of illustration and example only and is not to be taken by way of limitation, the scope of the present invention being limited only by the terms of the appended claims.

## Claims

1. A photoprocessing method for processing an object (20) to be processed by a laser beam, comprising the steps of:
introducing the laser beam into a mask member (12);
irradiating the laser beam passed through a light-transmittable portion (12a) formed in the mask member onto the object (20) to be processed; and
processing a portion of said object (20) corresponding to said light-transmittable portion (12a) by the irradiated laser beam, wherein, before introducing said laser beam into said mask member, the laser beam is processed so as to correspond to the shape of a light-transmittable portion formed in said mask member,
**characterized in that** said laser beam is processed by using a diffraction optical system, a Fresnel lens array, a diffraction grating, a grating or a combination of spherical, cylindrical and/or achromatic lenses.

2. The photoprocessing method according to claim 1, wherein
in processing the laser beam so as to correspond to the shape of the light-transmittable portion (12a) formed in the mask member (12), the laser beam is processed into a shape having a slightly larger area than that of the light-transmittable portion (12a).

3. The photoprocessing method according to claim 1, wherein
in irradiating the laser beam passed through the light-transmittable portion formed in the mask member onto the object to be processed, the laser beam is projected onto the object to be processed by a projection optical system (13), wherein
letting a be the distance between the mask member (12) and the projection optical system (13), b be the distance between the projection optical system (13) and the object (20) to be processed, and f be the focal length of the projection optical system, the mask member, the projection optical system and the object to be processed are so arranged as to satisfy 1 / a + 1 / b = 1 / f.

4. The photoprocessing method according to claim 1, wherein
at least two of the laser beam, the mask member (12) and the object (20) to be processed are moved, to successively process the object to be processed.

5. The photoprocessing method according to claim 4, wherein
the position where said laser beam is irradiated is fixed, and the mask member (12) and the object (20) to be processed are relatively moved, to successively process the object (20) to be processed.

6. An apparatus for processing an object by a laser beam according to the method as claimed in any of claims 1 to 5, comprising
a laser beam source (10),
a mask member (12) including light-transmittable portions (12a) and arranged between an object (20) to be processed and the laser beam source (10),
a light guide (11) arranged between said laser beam source (10) and said mask member (12) for processing the laser beam so as to correspond to the shape of said light transmittable portion provided in said mask member (12), and
optical means (13) for irradiating the laser beam passed through the light-transmittable portions (12a) onto the object (20) to be processed,
**characterized in that** said light guide (11) includes a diffraction optical system, a Fresnel lens array, a diffraction grating, a grating or a combination of spherical, cylindrical and/or achromatic lenses.

## Patentansprüche

1. Licht-Verarbeitungsverfahren zum Verarbeiten eines mittels eines Laserstrahls zu verarbeitenden Gegenstands (20), mit den folgenden Schritten:
Einführen des Laserstrahls in ein Maskenglied (12); Einstrahlen des Laserstrahls, der durch einen in dem Maskenglied gebildeten lichtdurchlässigen Abschnitt (12a) hindurchtritt, auf den zu verarbeitenden Gegenstand (20); und
Verarbeiten eines Teils des Gegenstands (20), der dem lichtdurchlässigen Abschnitt (12a) entspricht, durch den eingestrahlten Laserstrahl, wobei vor dem Einleiten des Laserstrahls in das Maskenglied der Laserstrahl derart bearbeitet wird, daß er der Form eines in dem Maskenglied gebildeten lichtdurchlässigen Abschnitts entspricht,
**dadurch gekennzeichnet, daß** der Laserstrahl unter Verwendung eines optischen Beugungssystems, einer Fresnel-Linsenanordnung, eines Beugungsgitters, eines Gitters oder einer Kombination aus sphärischen, zylindrischen und/oder achromatischen Linsen bearbeitet wird.

2. Licht-Verarbeitungsverfahren nach Anspruch 1, **dadurch gekennzeichnet,**
**daß** beim Bearbeiten des Laserstrahls derart, daß er der Form eines in dem Maskenglied (12) gebildeten lichtdurchlässigen Abschnitts (12a) entspricht, der Laserstrahl zu einer Form bearbeitet wird, die eine geringfügig größere Fläche als diejenige des lichtdurchlässigen Abschnitts (12a) hat.

3. Licht-Verarbeitungsverfahren nach Anspruch 1, **dadurch gekennzeichnet,**
**daß** beim Einstrahlen des Laserstrahls, der durch den in dem Maskenglied gebildeten lichtdurchlässigen Abschnitt (12a) hindurchtritt, auf den zu verarbeitenden Gegenstand (20) der Laserstrahl mittels eines optischen Projektionssystems (13) auf den zu verarbeitenden Gegenstand projiziert wird, wobei,
wenn a die Entfernung zwischen dem Maskenglied (12) und dem optischen Projektionssystem (13) ist, b die Entfernung zwischen dem optischen Projektionssystem (13) und dem zu verarbeitenden Gegenstand (20) ist und f die Brennweite des optischen Projektionssystems ist, das Maskenglied, das optische Projektionssystem und der zu verarbeitende Gegenstand (20) so angeordnet sind, daß sie die Gleichung 1/a + 1/b = 1/f erfüllen.

4. Licht-Verarbeitungsverfahren nach Anspruch 1, **dadurch gekennzeichnet,**
**daß** mindestens zwei der Elemente der durch den Laserstrahl, das Maskenglied (12) und den zu verarbeitenden Gegenstand (20) gebildeten Gruppe bewegt werden, um den zu verarbeitenden Gegenstand nach und nach zu verarbeiten.

5. Licht-Verarbeitungsverfahren nach Anspruch 4, **dadurch gekennzeichnet,**
**daß** die Position, bei der der Laserstrahl eingestrahlt wird, festgelegt wird und daß das Maskenglied (12) und der zu verarbeitende Gegenstand (20) relativ-bewegt werden, um den zu verarbeitenden Gegenstand nach und nach zu verarbeiten.

6. Vorrichtung zum Verarbeiten eines Gegenstands mittels eines Laserstrahls gemäß dem Verfahren nach einem der Ansprüche 1 bis 5, welche aufweist:
eine Laserstrahl-Quelle (10);
ein Maskenglied (12), das lichtdurchlässige Abschnitte (12a) enthält und das zwischen einem zu verarbeitenden Gegenstand (20) und der Laserstrahl-Quelle (10) angeordnet ist;
eine Lichtführung (11), die zwischen der Laserstrahl-Quelle (10) und dem Maskenglied (12) angeordnet ist, um den Laserstrahl derart zu bearbeiten, daß er der Form des in dem Maskenglied (12) gebildeten lichtdurchlässigen Abschnitts entspricht; und
ein optisches Mittel (13) zum Einstrahlen des Laserstrahls, der durch die in dem Maskenglied gebildeten lichtdurchlässigen Abschnitte (12a) hindurchtritt, auf den zu verarbeitenden Gegenstand (20),
**dadurch gekennzeichnet, daß** die Lichtführung (11) ein optisches Beugungssystem, eine Fresnel-Linsenanordnung, ein Beugungsgitter, ein Gitter oder eine Kombination aus sphärischen, zylindrischen und/oder achromatischen Linsen enthält.

## Revendications

1. Procédé de traitement à la lumière pour le traitement d'un objet (20) destiné à subir un traitement par un faisceau laser, comprenant des étapes consistant à:
introduire ledit faisceau laser dans un membre de masque (12) ;
irradier par ledit faisceau laser, passé à travers une partie (12a) transmissible pour la lumière et formée dans ledit membre de masque, ledit objet (20) destiné à subir ledit traitement; et
effectuer le traitement d'une partie dudit objet (20), correspondant à ladite partie (12a) transmissible pour la lumière, par ledit faisceau laser d'irradiation et, avant l'introduction dudit faisceau laser dans ledit membre de masque, ledit faisceau laser subit un traitement de manière à ce qu'il corresponde à la forme de ladite partie transmissible pour la lumière et formée dans ledit membre de masque,
**caractérisé en ce que** le traitement dudit faisceau laser s'effectue en utilisant un système optique de diffraction, un agencement de lentilles de Fresnel, un réseau de diffraction, un réseau ou une combinaison de lentilles sphériques, cylindriques et/ou achromatiques.

2. Procédé de traitement à la lumière selon la revendication 1, **caractérisé en ce que**, lors du traitement dudit faisceau laser de manière à ce qu'il corresponde à la forme de ladite partie (12a) transmissible pour la lumière et formée dans ledit membre de masque (12), ledit faisceau laser subit un traitement vers une forme ayant une superficie légèrement supérieure à celle de ladite partie (12a) transmissible pour la lumière.

3. Procédé de traitement à la lumière selon la revendication 1, **caractérisé en ce que**, lors de l'irradiation par ledit faisceau laser, passé à travers ladite partie transmissible pour la lumière et formée dans ledit membre de masque, dudit objet destiné à subir un traitement, ledit faisceau laser est projeté sur ledit objet destiné à subir un traitement par un système optique de projection (13), dans lequel,
soit a la distance entre ledit membre de masque (12) et ledit système optique de projection (13), b la distance entre ledit système optique de projection (13) et ledit objet (20) destiné à subir un traitement et f la distance focale dudit système optique de projection, ledit système optique de projection et ledit objet destiné à subir un traitement sont arrangés de manière à satisfaire l'équation 1/a + 1/b = 1/f.

4. Procédé de traitement à la lumière selon la revendication 1, **caractérisé en ce qu'**au moins deux éléments parmi le groupe comprenant ledit faisceau laser, ledit membre de masque (12) et ledit objet (20) destiné à subir un traitement sont déplacés afin d'effectuer succesivement le traitement dudit objet destiné à subir un traitement.

5. Procédé de traitement à la lumière selon la revendication 4, **caractérisé en ce que** la position dans laquelle l'irradiation par ledit faisceau laser s'effectue est fixée, et ledit membre de masque (12) et ledit objet (20) destiné à subir un traitement sont déplacés relativement afin d'effectuer succesivement le traitement dudit objet destiné à subir un traitement.

6. Dispositif pour le traitement d'un objet par un faisceau laser selon le procédé défini par l'une quelconque des revendications 1 à 6, comprenant:
une source de faisceau laser (10);
un membre de masque (12) comportant des parties (12a) transmissibles pour la lumière et agencé entre ledit objet (20) destiné à subir un traitement et ladite source de faisceau laser (10) ;
un guide de lumière (11) agencé entre ladite source de faisceau laser (10) et ledit membre de masque (12) pour effectuer le traitement dudit membre de masque de manière à ce qu'il corresponde à la forme de ladite partie transmissible pour la lumière et prévue dans ledit membre de masque (12); et
un moyen optique (13) pour effectuer l'irradiation par ledit faisceau laser, passé à travers lesdites parties (12a) transmissibles pour la lumière, dudit objet (20) destiné à subir un traitement,
**caractérisé en ce que** ledit guide de lumière (11) comporte un système optique de diffraction, un agencement de lentilles de Fresnel, un réseau de diffraction, un réseau ou une combinaison de lentilles sphériques, cylindriques et/ou achromatiques.
